# EUROPÄISCHE PATENTSCHRIFT

(11) **EP 1 801 973 B1**
(45) Veröffentlichungstag und Bekanntmachung des Hinweises auf die Patenterteilung: **21.01.2009**
(21) Anmeldenummer: 07004639.6
(22) Anmeldetag: 27.01.1998
(51) Int. Cl.: H03K 17/06, H03K 17/16, H03K 17/082

(54) **Steuergerät**
Control unit
Appareil de commande

(30) Priorität: 28.01.1997 DE 19702949
(43) Veröffentlichungstag der Anmeldung: 27.06.2007
(62) Teilanmeldung aus: 98101336.0
(73) Patentinhaber: AFL Europe GmbH, 72636 Frickenhausen (DE)
(72) Erfinder: Flock, Horst, 72766 Reutlingen (DE)
(74) Vertreter: Hoeger, Stellrecht & Partner Patentanwälte

(56) Entgegenhaltungen:
- DE-A- 3 405 936
- US-A- 5 583 420

## Beschreibung

Die Erfindung betrifft ein Steuergerät zur Ansteuerung einer Last, insbesondere eines Lüftermotors eines Kraftfahrzeugs, umfassend eine Steuerschaltung, welche entsprechend eines Soll-Werts ein aufeinanderfolgende Einschaltintervalle und Ausschaltintervalle aufweisendes PWM-Signal erzeugt, eine Einschaltstufe und eine Ausschaltstufe, welche gemäß dem PWM-Signal über einen Endstufenschalter den Speisestrom für die Last pulsweitenmoduliert schalten.

Ein derartiges Steuergerät ist beispielsweise aus der WO 95/28767 bekannt.

Bei dieser Schaltung wird eine Gate-Versorgungsspannung des Endstufenschalters mit aufwendigen Mitteln erzeugt.

Ferner ist auch aus der DE-A-34 05 936 eine Steuerschaltung für einen FET-Endstufenschalter bekannt, bei welcher eine Diode und ein Kondensator vorhanden sind.

Außerdem ist aus der US 5,583,420 ein Steuergerät zum pulsweitenmodulierten Ansteuern einer Feldwicklung bekannt, welche einen Strom über eine Freilaufdiode überwacht, um ein Generatorfeld in der Feldwicklung zu steuern.

Der Erfindung liegt die Aufgabe zugrunde, ein Steuergerät der eingangs beschriebenen Art so zu verbessern, dass Lastfunktionen erkennbar sind.

Diese Aufgabe wird bei einem Steuergerät der eingangs beschriebenen Art erfindungsgemäß dadurch gelöst, dass zwischen dem Endstufenschalter und der Last ein Messabgriff vorgesehen ist, welcher mit einer Messschaltung verbunden ist, und wobei eine Überwachungsschaltung durch Unterdrücken mindestens eines PWM-Einschaltintervalls ein Messausschaltintervall erzeugt innerhalb des Messausschaltintervalls mit der Messschaltung die Spannung am Messabgriff überwacht und mit einem Referenzwert vergleicht.

Der Vorteil der erfindungsgemäßen Lösung ist darin zu sehen, dass diese die Möglichkeit schafft, das Freilaufverhalten der Last zu überwachen und somit Funktionsausfälle der Last zu überprüfen.

Ist die Last beispielsweise ein Gleichstrommotor, so kann während des Messausschaltintervalls beispielsweise überwacht werden, ob der Motor im Freilauf weiterläuft, oder blockiert ist.

Prinzipiell wäre es denkbar, während des gesamten Messausschaltintervalls die Spannung am Messabgriff zu überwachen. Dies ist jedoch aufwendig und erfordert ein erhebliches Speichervermögen.

Aus diesem Grund sieht eine besonders einfache und vorteilhafte Lösung vor, dass die Messschaltung innerhalb des Messintervalls zu einer bestimmten Überwachungszeit die Spannung am Messabgriff ermittelt.

Wird die Überwachungszeit in Abstimmung an das Verhalten der Last, beispielsweise das Nachlaufen des Gleichstrommotors, festgelegt, so lässt sich damit mit ausreichender Genauigkeit ermitteln, ob der Gleichstrommotor blockiert ist oder weiterläuft.

Insbesondere die Frage, ob ein Motor blockiert ist oder weiterläuft, lässt sich mit einem besonders einfachen Verfahren ermitteln, nämlich dadurch, dass die Überwachungsschaltung überprüft, ob die Spannung am Messabgriff zu der bestimmten Überwachungszeit einen Mindestwert überschreitet oder nicht. Wird der Mindestwert überschritten, so ist davon auszugehen, dass der Gleichstrommotor ein ausreichendes Nachlaufverhalten zeigt.

Da eine Überprüfung der Last nur in relativ großen Zeitabständen notwendig und sinnvoll ist, ist vorzugsweise vorgesehen, dass die Überwachungsschaltung periodisch, beispielsweise nach einem bestimmten Zeitraum ein Messausschaltintervall initiiert.

Eine zu der vorstehenden Ausführungsform alternative oder ergänzende Weiterbildung des erfindungsgemäßen Steuergeräts sieht vor, dass eine weitere Messschaltung vorgesehen ist, welche eine Versorgungsspannung des Steuergeräts erfasst.

Mit dem Erfassen der Versorgungsspannung lassen sich ebenfalls Überwachungsaufgaben bezüglich der Last durchführen.

So sieht ein vorteilhaftes Ausführungsbeispiel vor, dass die Überwachungsschaltung ein Messeinschaltintervall definierter Dauer generiert und zu Beginn und zum Ende dieses Messeinschaltintervalls die Versorgungsspannung unter Last erfasst und dass die Überwachungsschaltung die Differenz zwischen der Versorgungsspannung zu Beginn und am Ende des Messeinschaltintervalls ermittelt und mit einem Referenzwert vergleicht.

Die Differenz der Versorgungsspannung zu Beginn und am Ende des Messeinschaltintervalls gibt ein Maß dafür, inwieweit die Last eine sinnvolle Größe aufweist und das erfindungsgemäße Steuergerät zu stark oder zu wenig belastet.

So ist beispielsweise vorgesehen, dass die Überwachungsschaltung bei einer Differenz, welche kleiner als ein Mindestreferenzwert ist, eine fehlende Last meldet.

Alternativ dazu ist es aber auch denkbar, wenn die Überwachungsschaltung bei Überschreiten eines Maximalreferenzwertes einen Kurzschluss meldet, da in diesem Fall die Last das Steuergerät zu stark belastet.

In beiden Fällen ist es aber auch denkbar, die Überwachungsschaltung so zu konzipieren, dass diese im Fall einer fehlenden Last oder im Fall eines Kurzschlusses das Steuergerät abschaltet.

Das Messeinschaltintervall, welches von der Überwachungsschaltung initiiert ist, könnte beispielsweise ein PWM-abhängiges Einschaltintervall sein. Da ein derartiges Einschaltintervall jedoch in manchen Fällen zu kurz sein kann und somit Fehlmessungen auftreten können, ist vorzugsweise vorgesehen, dass die Überwachungsschaltung ein PWM-unabhängiges Messeinschaltintervall generiert.

Prinzipiell wäre es denkbar, ein derartiges Messeinschaltintervall nach jedem beliebigen Messausschaltintervall folgen zu lassen.

Da jedoch insbesondere die PWM-abhängigen Ausschaltintervalle sehr kurz sein können und sich somit die Versorgungsspannung in diesen kurzen Ausschaltintervallen unwesentlich von der Belastung durch die Last erholen kann, sieht ein vorteilhaftes Ausführungsbeispiel vor, dass die Überwachungsschaltung unmittelbar nach dem Messausschaltintervall das Messeinschaltintervall generiert.

Ferner liegt der Erfindung ergänzend oder alternativ die Aufgabe zugrunde, ein Steuergerät der gattungsgemäßen Art zu schaffen, bei welchem mit möglichst einfachen Mitteln ein zuverlässiges Schalten des FET-Endstufenschalters erreichbar ist.

Diese Aufgabe wird ergänzend oder alternativ dadurch gelöst, dass das Steuergerät einen FET-Endstufenschalter zum Schalten eines von einem Spannungsversorgungsanschluss zum Ausgang fließenden Speisestroms für die Last entsprechend den Ein- und Ausschaltintervallen aufweist, dass, eine Einschaltstufe und eine Ausschaltstufe zum Ein- und Ausschalten einer Gate-Spannung des Endstufenschalters vorgesehen sind, welche entsprechend dem Ein- und Ausschaltintervall des PWM-Signals von der Steuerschaltung angesteuert sind, und dass eine Gate-Spannungsversorgung für die Einschaltstufe zur Erzeugung einer Gate-Versorgungsspannung zum Durchschalten des Endstufenschalters während des Einschaltintervalls erzeugbar ist.

Eine Ausführung eines derartigen Steuergeräts sieht vor, dass die Gate-Spannungsversorgung eine Ladungspumpenschaltung, umfassend einen zwischen einem Plusanschluss und einem Mittelabgriff in Durchlassrichtung liegende Diode und einen zwischen dem Mittelabgriff und einem Minusanschluss liegenden Kondensator aufweist, dass der Mittelabgriff mit der Einschaltstufe verbunden ist und dass ein Potential am Minusanschluss der Ladungspumpenschaltung sich entsprechend einem Potential am Ausgang ändert und somit während des Ausschaltintervalls ein über die Diode fließender Strom den Kondensator auflädt und während des gesamten Einschaltintervalls die Diode sperrt und die Kapazität am Mittelabgriff eine Gate-Versorgungsspannung liefert, welche mindestens einer Spannung an einem versorgungsseitigen Anschluss des Endstufenschalters entspricht.

Der Vorteil der erfindungsgemäßen Lösung liegt somit zunächst in ihrer konzeptionellen Einfachheit die einen aufwendigen Aufbau überflüssig macht.

Darüber hinaus ist der Vorteil der erfindungsgemäßen Lösung darin zu sehen, dass mit dieser in einfacher Art und Weise eine derart hohe Gate-Versorgungsspannung erzeugbar ist, welche ein sicheres und vollständiges Durchschalten des Endstufenschalters gewährleistet.

Ein besonders bevorzugtes Ausführungsbeispiel der erfindungsgemäßen Lösung sieht daher vor, die am Mittelabgriff der Ladungspumpenschaltung anliegende Gate-Versorgungsspannung ungeregelt dem Gate-Anschluss zuzuführen. Der Vorteil dieser Lösung liegt in dem besonders einfachen und somit kostengünstigen Aufbau des erfindungsgemäßen Steuergeräts.

Zweckmäßigerweise ist bei einem vorteilhaften Ausführungsbeispiel der erfindungsgemäßen Lösung vorgesehen, dass die Kapazität in der Ladungspumpenschaltung so dimensioniert ist, dass diese bei für das PWM-Signal vorgesehenem maximalem Ausschaltintervall und maximalem Einschaltintervall während des gesamten Einschaltintervalls eine Gate-Versorgungsspannung liefert, welche größer ist als die Spannung am versorgungsseitigen Anschluss des Endstufenschalters. Durch diese Dimensionierung der Kapazität wird eine ausreichend hohe Gate-Versorgungsspannung während des gesamten Einschaltintervalls zur Verfügung gestellt, ohne dass zusätzliche Maßnahmen erforderlich sind.

Ferner ist es besonders günstig, wenn die Leckströme bei der Erzeugung der Gate-Spannung während des gesamten Einschaltintervalls die Kapazität nur so weit entladen, dass deren Spannung am Ende des maximalen Einschaltintervalls größer ist als die Spannung am versorgungsseitigen Anschluss des Endstufenschalters.

Insbesondere ist es vorteilhaft, wenn die Kapazität so dimensioniert ist, dass er sich während des maximalen Einschaltintervalls nicht mehr als zur Hälfte entlädt. In diesem Fall kann der Abfall der Gate-Versorgungsspannung so gering gehalten werden, dass er sich nicht negativ auf die damit verbundene Änderung in der Ansteuerung des Endstufenschalters auswirkt.

Noch besser ist es, wenn die Kapazität so dimensioniert ist, dass er sich während des maximalen Einschaltintervalls um weniger als 20%, noch besser weniger als 10% entlädt.

Eine hinsichtlich der Durchsteuerung des Endstufenschalters besonders vorteilhafte Lösung sieht vor, dass die Gate-Versorgungsspannung während des gesamten Einschaltintervalls mindestens 3 Volt über der Spannung am versorgungsseitigen Anschluss des Endstufenschalters liegt. Damit ist sichergestellt, dass während des gesamten Einschaltintervalls der Endstufenschalter stets vollständig durchgesteuert ist, so dass auch Schwankungen in der Gate-Versorgungsspannung sich nicht auf die Durchsteuerung des Endstufenschalters auswirken.

Eine besonders günstige Lösung eines erfindungsgemäßen Steuergeräts sieht vor, dass der Minusanschluss der Ladungspumpenschaltung auf einem Potential zwischen dem des ausgangsseitigen Anschlusses des Endstufenschalters und dem des Ausgangs liegt. Diese Lösung stellt sicher, dass das Potential des Minusanschlusses entsprechend dem Potential des Ausgangs variiert, lässt jedoch offen, inwieweit das Potential des Minusanschlusses direkt dem des Ausgangs entspricht.

Ferner sieht eine besonders vorteilhafte Realisierung des erfindungsgemäßen Steuergeräts vor, dass der Plusanschluss der Ladungspumpenschaltung auf einem Potential liegt, welches mindestens dem am versorgungsseitigen Anschluss des Endstufenschalters entspricht.

Eine besonders einfache und günstige Realisierung der erfindungsgemäßen Lösung sieht vor, dass der Plusanschluss des Ladungspumpenschaltung mit einer Versorgungsleitung des Steuergeräts verbunden ist.

Vorzugsweise liegt dabei die Versorgungsleitung auf einer stabilisierten Spannung, so dass eine Beschädigung des Endstufenschalters durch eine überhöhte Gate-Versorgungsspannung ausgeschlossen ist.

In besonders einfacher Weise lässt sich die Spannung am Plusanschluss gegen Einbrüche dann stabilisieren, wenn hierzu ein Kondensator Verwendung findet, der insbesondere auch dazu eingesetzt wird, ein schnelles Aufladen der Kapazität der Ladungspumpenschaltung unmittelbar nach Übergang vom Einschaltintervall in das Ausschaltintervall sicherzustellen.

Ein besonders vorteilhaftes Ausführungsbeispiel eines erfindungsgemäßen Steuergeräts sieht vor, dass die Gate-Spannungsversorgung ausschließlich Dioden und Kondensatoren umfasst und somit insbesondere keine Bauteile, wie beispielsweise Transistoren, zur Regelung der Gate-Versorgungsspannung erforderlich sind.

Im Zusammenhang mit der bisherigen Erläuterung der einzelnen Ausführungsbeispiele wurde nicht näher auf die Ausbildung der Einschaltstufe eingegangen.

Um bei der induktiven Last Spannungsspitzen zu vermeiden, ist vorzugsweise vorgesehen, dass der Einschaltstufe ein als Tiefpass ausgebildetes Zeitglied zugeordnet ist, mit welchem der Anstieg der Gate-Spannung beim Einschalten festlegbar ist.

Vorzugsweise ist dabei vorgesehen, dass ein Kondensator des Tiefpasses zwischen dem Gate-Anschluss und Masse liegt.

Die Einschaltstufe selbst kann in unterschiedlichster Art und Weise ausgebildet sein. Eine vorteilhafte Ausbildung der Einschaltstufe sieht vor, dass diese einen von der Steuerschaltung steuerbaren Schalttransistor aufweist.

Desgleichen ist, insbesondere zur Vermeidung negativer Spannungsspitzen beim Ausschalten, der Ausschaltstufe ein als Tiefpass ausgebildetes Zeitglied zugeordnet.

Dabei arbeitet vorzugsweise das der Ausschaltstufe zugeordnete Zeitglied mit demselben Kondensator zwischen dem Gate-Anschluss und Masse.

Ferner ist vorzugsweise die Ausschaltstufe ebenfalls so ausgebildet, dass sie einen von der Steuerschaltung geschalteten Schalttransistor aufweist.

Vorzugsweise ist vorgesehen, dass eine Zeitkonstante des Tiefpasses für das Einschalten und/oder das Ausschalten mindestens einen Faktor fünf größer ist als eine Zeitkonstante einer zur Last parallel geschalteten Freilaufdiode, so dass das Auftreten von Spannungsspitzen weitgehend vermieden werden kann.

Weitere Merkmale und Vorteile der erfindungsgemäßen Lösung sind Gegenstand der Beschreibung sowie der zeichnerischen Darstellung eines Ausführungsbeispiels.

In der Zeichnung zeigen:
- Fig. 1: eine schematische Schaltung eines erfindungsgemäßen Steuergerätes und
- Fig. 2: eine Darstellung von PWM-Signalen, Messausschaltintervallen und Messeinschaltintervallen bei dem erfindungsgemäßen Steuergerät.

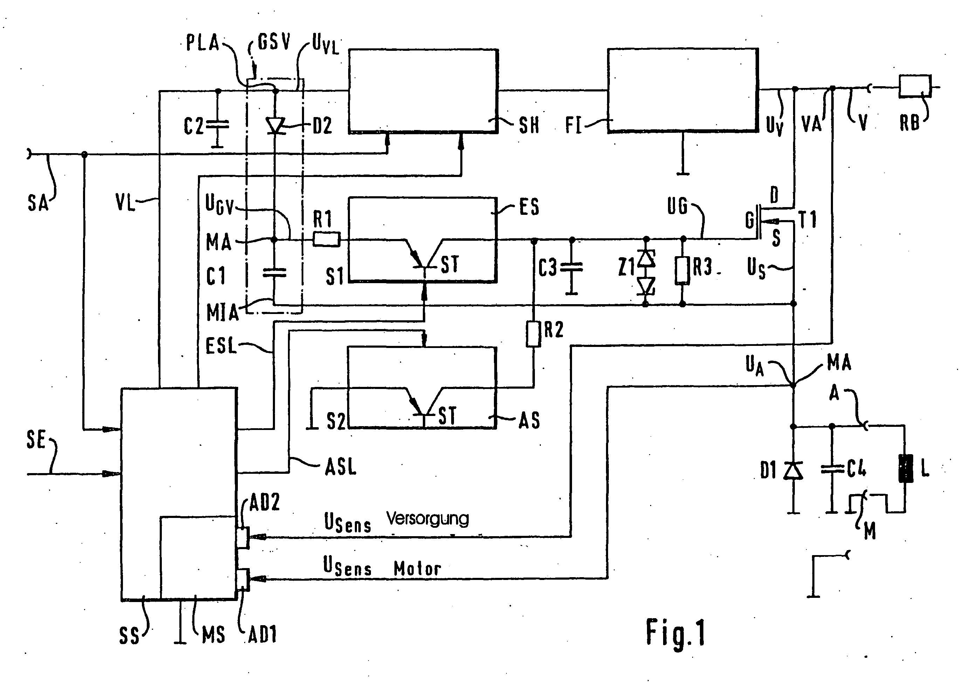

Ein Ausführungsbeispiel eines erfindungsgemäßen Steuergeräts, dargestellt in Fig. 1, umfasst einen N-Kanal MOSFET-Transistor T1 als Endstufenschalter, dessen Drain-Anschluss D mit einem Spannungs-Versorgungsanschluss V für eine Versorgungsspannung U_{V} verbunden ist. Diese Versorgungsspannung U_{V} ist beispielsweise das + 12 Volt Bordnetz eines Kraftfahrzeugs.

Ein Source-Anschluss S des Endstufenschalters T1 ist mit einem Ausgang A verbunden.

Zwischen dem Ausgang A und Masse M liegt eine insbesondere induktive Last L, welche beispielsweise durch einen Motor eines Lüfters eines Kraftfahrzeugs repräsentiert wird. Ferner liegen noch zwischen dem Ausgang A und der Masse M ein Kondensator C4 und eine Freilaufdiode D1. Diese Freilaufdiode D1 dient dazu, beim Ausschalten des Endstufenschalters T1 einen Stromfluss zwischen der Masse M und dem Ausgang A zuzulassen, durch welchen eine aufgrund der induktiven Last auftretende Spannungsspitze abgebaut wird.

Eine Ansteuerung des Endstufenschalters T1 erfolgt über einen Gate-Anschluss G desselben mittels einer Einschaltstufe ES und einer Ausschaltstufe AS, die eine Steuerung einer Gate-Spannung UG am Gate-Anschluss erlauben.

Die Einschaltstufe ES und die Ausschaltstufe AS sind beide angesteuert durch eine Steuerschaltung SS, welcher über eine Sollwert-Eingabeleitung SE ein Sollwert für ein PWM-Signal vorgebbar ist. Weiter ist die Steuerschaltung SS über einen Systemaktivierungsleitung SA aktivierbar.

Eine Stromversorgung der Steuerschaltung SS erfolgt über ein dem Spannungs-Versorgungsanschluss V nachgeschaltetes Filter FI und eine diesem nachgeordnete Selbsthalteschaltung SH, welche mit einer Versorgungsleitung VL der Steuerschaltung SS verbunden ist und in dieser eine Spannung U_{VL} erzeugt.

Zwischen der Versorgungsleitung VL und der Masse M liegt ein Kondensator C2. Ferner ist mit der Versorgungsleitung SL eine Diode D2 verbunden, welche mit einem Kondensator C1 in Reihe geschaltet ist, der seinerseits wiederum mit dem Ausgang A verbunden ist. Die Diode D2 ist dabei so geschaltet, dass ein Strom von der Versorgungsleitung VL zum Kondensator C1, und zwar zur Aufladung desselben, fließen kann, wenn der Endstufenschalter T1 ausgeschaltet ist und somit der Kondensator C1 mit der Masse verbunden ist.

Die Diode D2 und der Kondensator C1 bilden eine als Ladungspumpenschaltung ausgebildete Gate-Spannungsversorgung GSV mit einem mit der Versorgungsleitung VL verbundenen Plusanschluss PLA und einen mit dem Ausgang A verbundenen Minusanschluss MIK, wobei eine Gate-Versorgungsspannung U_{GV} an einem Mittelabgriff MA zur Verfügung steht.

Mit dem zwischen der Diode D2 und dem Kondensator C2 liegenden Mittelabgriff MA ist über einen Widerstand R1 die Einschaltstufe ES verbunden, welche einen Schalttransistor ST aufweist, der seinerseits über eine mit der Steuerschaltung SS verbundene Einschaltsteuerleitung ESL ansteuerbar ist.

Bei durchgeschalteter Einschaltstufe ES fließt von dem Mittelabgriff MA über den Widerstand R1 ein Strom zum Gate-Anschluss G des Endstufenschalters T1, wobei sich die Gate-Versorgungsspannung UG ausbildet.

Zur Verzögerung des Anstiegs der Gate-Versorgungsspannung UG unmittelbar nach dem Einschalten der Einschaltstufe ES ist der Gate-Anschluss G des Endstufenschalters T1 über einen Kondensator C3 mit Masse verbunden, wobei der Widerstand R1 und der Kondensator C3 ein RC-Glied bilden, welches die Gate-Versorgungsspannung UG unmittelbar nach dem Einschalten der Einschaltstufe ES mit einer definierten Zeitverzögerung ansteigen lässt und somit auch eine Flankensteilheit eines Anstiegs einer entsprechenden Source-Spannung US limitieren.

Zur Absicherung der Gate-Versorgungsspannung UG liegen zwischen dem Gate-Anschluss G des Endstufenschalters T1 und dem Source-Anschluss S desselben oder dem Ausgang A eine Zenerdiodenreihe Z1 und parallel dazu einen Widerstand R3, wobei der Widerstand R3 dazu dient, bei ausgeschaltetem Endstufenschalter T1 diesen Zustand zu erhalten.

Die Ausschaltstufe AS umfasst ebenfalls einen Schalttransistor ST und dient dazu, den Gate-Anschluss G des Endstufenschalters T1 mit Masse M zu verbinden, wobei zwischen der Ausschaltstufe AS und dem Gate-Anschluss G des Endstufenschalters T1 ein Widerstand R2 liegt, welcher mit dem Kondensator C3 ebenfalls ein RC-Glied bildet, durch welches ein Abfallen der Gate-Versorgungsspannung UG mit definierter Zeitverzögerung und somit ein entsprechendes Abfallen der Source-Spannung US festlegbar sind.

Vorzugsweise haben die RC-Glieder R1 C3 und R2 C3 eine vergleichbare, günstigerweise eine identische Zeitkonstante.

Die Diode D2 bildet mit dem Kondensator C1 eine Ladungspumpe zur Erzeugung einer Gate-Versorgungsspannung UG, welche höher liegt als die Spannung U_{V} am Versorgungsspannungsanschluss V des Steuergeräts.

Das erfindungsgemäße Steuergerät arbeitet dabei wie folgt.

Bei der Aktivierung des Steuergeräts über die Systemaktivierungsleitung SA wird einerseits die Selbsthaltung SH und andererseits die Steuerschaltung SS aktiviert. Damit liegt an der Versorgungsleitung VL die Spannung U_{VL} an, welche ungefähr der Spannung U_{V} am Spannungsversorgungsanschluss V entspricht.

Ferner ist in diesem Zustand der Endstufenschalter T1 ausgeschaltet, so dass der Kondensator C1 einerseits über einen von der Versorgungsleitung VL durch die Diode D2 und über Mittelabgriff MA fließenden Strom und andererseits über einen über die Last L zum Ausgang A und von diesem auf den Kondensator C1 fließenden Strom aufgeladen wird. Die Spannung, mit welcher der Kondensator C1 aufgeladen wird, entspricht im wesentlichen der Spannung U_{VL}, welche dann auch an dem Mittelabgriff MA anliegt.

Wird nun durch die Steuerschaltung SS die Einschaltstufe ES aktiviert und deren Schalttransistor ST durchgeschaltet, so führt die am Mittelabgriff MA anliegende Spannung U_{VL} dazu, dass ein Strom über den Widerstand R1 zum Gate-Anschluss G des Endstufenschalters T1 fließt und sich, zeitverzögert durch das RC-Glied R1, C3 die Gate-Spannung UG aufbaut.

Mit sich aufbauender Gate-Spannung UG schaltet der Endstufenschalter T1 durch und die Source-Spannung US, die bei ausgeschaltetem Endstufenschalter T1 im Anfangszustand ungefähr dem Potential der Masse M entspricht, steigt an, da der über den Endstufenschalter T1, den Ausgang A und die Last L zur Masse M fließende Strom das Potential am Source-Anschluss S des Endstufenschalters T1 ansteigen lässt und zwar bis maximal auf ungefähr die Versorgungsspannung U_{V} am Versorgungsspannungsanschluss V bei voll durchgesteuerten Endstufenschalter T1. Zu dieser Source-Spannung US addiert sich die am Kondensator C1 liegende Spannung, so dass eine Gate-Versorgungsspannung UG erreichbar ist, welche maximal ungefähr dem doppelten der Versorgungsspannung U_{V} entspricht, wenn U_{V} ungefähr gleich U_{VL} ist.

Der Kondensator C1 ist nun so dimensioniert, dass dessen Ladung ausreicht, um während des längst möglichen Einschaltintervalls EIV des von der Steuerschaltung SS erzeugten PWM-Signals Gate-Versorgungsspannung UG zu liefern, die deutlich höher ist als U_{V}, wobei UG vorzugsweise mindestens 3, noch besser 5 Volt über der Source-Spannung US liegt.

Zum Ausschalten steuert die Steuerschaltung über die Ausschaltleitung ASL den Schalttransistor ST der Ausschaltstufe AS an und schaltet gleichzeitig über die Einschaltsteuerleitung ESL den Schalttransistor der Einschaltstufe ES ab, so dass nunmehr der Gate-Anschluss G des Endstufenschalters T1 über die Ausschaltstufe AS und den Widerstand R2 mit der Masse M verbunden ist. Das Abfallen der Gate-Spannung UG wird dabei begrenzt durch das RC-Glied C3, R2.

Bei ausgeschaltetem Endstufenschalter T1 lädt sich der Kondensator C1 wieder auf, denn die Source-Spannung US nähert sich in diesem Fall wieder im wesentlichen dem Wert Null.

Ferner dient der Kondensator C2 dazu, um nach Abschalten des Endstufenschalters T1 einen ausreichend großen Strom über die Diode D2 zum möglichst schnellen Aufladen des Kondensators C1 fließen zu lassen.

Je nach dem wie groß das RC Glied R2, C3 gewählt ist, treten an dem Source-Anschluss S des Endstufenschalters T1 aufgrund der Freilaufdiode D1 mehr oder weniger große negative Abschaltspitzen, bedingt durch die induktive Last, auf, welche zum zusätzlichen Aufladen des Kondensators C1 auf eine Spannung verwendet werden können, die letztlich größer als die Versorgungsspannung UV am Spannungs-Versorgungsanschluss V ist.

Vorzugsweise ist die Kapazität des Kondensators C1 so groß gewählt, dass während der gesamten Einschaltdauer des Endstufenschalters T1 die Gate-Versorgungsspannung U_{VG} und folglich in diesem Fall auch näherungsweise die Gate-Spannung UG stets um mindestens 5 Volt über der Spannung am Drain-Anschluss D des Endstufenschalters T1 liegt.

Ferner sind die Kondensatoren C1 und C2 so dimensioniert, dass sich der Kondensator C1 nach dem Ausschalten des Endstufenschalters T1 so schnell auflädt, dass die minimale Ausschaltdauer des PWM-Signals unter 10% der Einschaltdauer, vorzugsweise bei ungefähr 1% derselben liegen kann.

Die Zeitkonstante der RC-Glieder R1, C3 und R2, C3 wird vorzugsweise so gewählt, dass diese bei 120 Nanosekunden liegt, während die Schaltverzögerung der Freilaufdiode D1 so gewählt wird, dass diese bei ungefähr einem Zehntel der Zeitkonstante der RC-Glieder R1, C3 und R2, C3 oder weniger, das heißt bei ungefähr 12 Nanosekunden oder weniger, liegt.

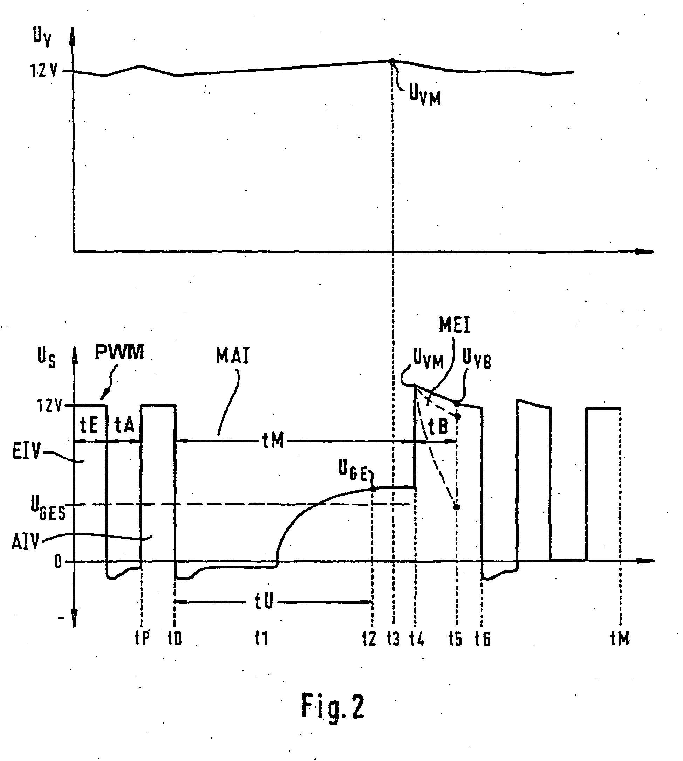

Das mit dem erfindungsgemäßen Steuergerät erzeugbare PWM-Signal ist in Fig. 2 im unteren Teil dargestellt, wobei die Einschaltdauer tE des Einschaltintervalls EIV und die Ausschaltdauer tA des Ausschaltintervalls AIV bei dem beispielhaft eingezeichneten PWM-Signal ungefähr gleich groß sind. Die Periodendauer des PWM-Signals beträgt tP.

Ferner ist in Fig. 2 die während der Ausschaltdauer tA noch auftretende negative Spannungsspitze, die aufgrund der induktiven Last und der Freilaufdiode D1 auftritt, erkennbar.

Das erfindungsgemäße Steuergerät umfasst zusätzlich zur Steuerschaltung SS eine mit der Steuerschaltung SS kommunizierende Messschaltung MS, wobei die Steuerschaltung SS gleichzeitig als Überwachungsschaltung arbeitet.

Mit der Messschaltung MS wird über einen ersten Analog-Digitalwandler AD1 an einem Messabgriff MA, welcher mit dem Ausgang A verbunden ist, die Spannung U_{A} während einer Messdauer tM eines Messausschaltintervalls MAI überwacht, währenddessen der Endstufenschalter T1 ausgeschaltet ist.

Während dieser Messdauer tM tritt, wie in Fig. 2 dargestellt, nach dem letzten Ausschalten des Endstufenschalters T1 als UA die durch die induktive Last L bedingte negative Spannungsspitze auf, die sich jedoch durch die Freilaufdiode D1 abbaut und zu positiven Werten übergeht, die aufgrund des Weiterlaufens des die Last L bildenden Lüftermotors als Generator auftreten. Der Lüftermotor erzeugt dabei eine Generatorspannung UGE, welche bei einem Wirkungsgrad von ungefähr 50% maximal ungefähr die Hälfte der Versorgungsspannung Uᵥ am Versorgungsspannungsanschluss V beträgt.

Zur Erfassung der Generatorspannung UGE des Lüftermotors erfolgt die Messung der am Messabgriff MA messbaren Spannung UA zu einer definierten Überwachungszeit tU nach dem letzten Ausschalten des PWM-Einschaltintervalls EIV.

Die Messschaltung MS wertet nach der gemessenen Generatorspannung UGE den Wert derselben aus, wobei am Auftreten der Generatorspannung UGE und der Größe derselben jeweils zu der festgelegten Überwachungszeit tU erkennbar ist, ob der als Last L dienende Lüftermotor im Freilauf weiterläuft oder beispielsweise nicht weiterläuft und blockiert ist.

Das heißt, dass die Messschaltung MS lediglich festzustellen braucht, ob die Generatorspannung UGE über einem Sollwert UGES liegt, um sicher zu sein, dass der Lüftermotor nicht blockiert ist, sondern ungehindert weiterläuft.

Das Ausschalten des PWM-Signals hat aber weiter den Effekt, dass die im Filter FI vorgesehenen Kondensatoren aufgeladen werden und die Versorgungsspannung U_{V} sich auf einen maximalen Wert U_{VM} erholen kann.

Wird noch nach dem Messausschaltintervall MAI der Endstufenschalter T1 während eines Messeinschaltintervalls MEI mit einer Belastungszeitdauer tB durchgeschaltet, so sinkt die Versorgungsspannung U_{V} von dem maximalen Wert U_{VM} auf einen Belastungswert U_{VB} ab, der dadurch bedingt ist, dass eine Entladung der Kondensatoren im Filter FI erfolgt da das Bordnetz, welches die Versorgungsspannung U_{V} liefert, selbst einen Widerstand aufweist.

An einem mit dem Versorgungsspannungsanschluss V verbundenen Versorgungsspannungsabgriff VA ist mittels eines Analog-Digital-Wandlers AD2 die Versorgungsspannung UV messbar und von der Messschaltung MS abfragbar, wobei die Differenz zwischen der maximalen Spannung U_{VM} und der Spannung U_{VB} nach einer Belastungszeitdauer tB erkennen lässt, inwieweit die an dem Anschluss A angeschlossene Last L einen vorgesehenen Strom fließen lässt und damit überhaupt vorhanden ist oder - beispielsweise aufgrund eines Kurzschlusses - einen zu großen Strom fließen lässt.

Beträgt die Differenz zwischen dem Wert U_{VM} und U_{VB} ungefähr gleich Null, so kann die Messschaltung MS erkennen, dass gar keine Last L angeschlossen ist.

Liegt beispielsweise die Differenz zwischen der Spannung UVM und U_{VB} in der Größenordnung von weniger als 1 Volt, jedoch größer 0,5 Volt, so ist beispielsweise der Dimensionierung entsprechende Last angeschlossen.

Liegt die Differenz zwischen UVM und UVB bei Spannungen von größer 2 bis 3 Volt, so liegt eine zu starke Belastung des Ausgangs A mittels der Last L, die beispielsweise einen Kurzschluss aufweist, vor, und die Steuerschaltung SS kann dies zum Anlass nehmen, das Steuergerät durch Abschalten der Selbsthaltung SH zu deaktivieren.

## Patentansprüche

1. Steuergerät zur Ansteuerung einer Last, insbesondere eines Lüftungsmotors eines Kraftfahrzeugs, umfassend eine Steuerschaltung, welche entsprechend eines Sollwerts ein aufeinanderfolgende Einschaltintervalle und Ausschaltintervalle aufweisendes PWM-Signal erzeugt, eine Einschaltstufe und eine Ausschaltstufe, welche gemäß dem PWM-Signal über einen Endstufenschalter den Speisestrom für die Last pulsweitenmoduliert schalten,
**dadurch gekennzeichnet, dass** zwischen dem Endstufenschalter (T1) und der Last (L) ein Messabgriff (MA) vorgesehen ist, welcher mit einer Messschaltung (MS) verbunden ist, und dass eine Überwachungsschaltung (SS) durch Unterdrücken mindestens eines PWM-Einschaltintervalls (EIV) ein Messausschaltintervall (MA) erzeugt und innerhalb des Messausschaltintervalls (MA) mit der Messschaltung (MS) die Spannung (U_{A}) am Messabgriff (MA) überwacht und mit einem Referenzwert (U_{GES}) vergleicht.

2. Steuergerät nach Anspruch 1, **dadurch gekennzeichnet, dass** die Messschaltung (MS) innerhalb des Messausschaltintervalls (MAI) zu einer bestimmten Überwachungszeit (tU) die Spannung am Messabgriff (MA) ermittelt.

3. Steuergerät nach Anspruch 1 oder 2, **dadurch gekennzeichnet, dass** die Überwachungsschaltung (SS) überprüft, ob die Spannung (U_{A}) am Messabgriff (MA) einen Mindestwert (U_{GES}) überschreitet.

4. Steuergerät nach einem der voranstehenden Ansprüche, **dadurch gekennzeichnet, dass** die Überwachungsschaltung (SS) periodisch ein Messausschaltintervall (MAI) initiiert.

5. Steuergerät nach dem Oberbegriff des Anspruchs 1 oder nach einem der voranstehenden Ansprüche, **dadurch gekennzeichnet, dass** eine weitere Messschaltung (MS) vorgesehen ist, welche eine Versorgungsspannung (Uᵥ) des Steuergeräts erfasst.

6. Steuergerät nach Anspruch 5, **dadurch gekennzeichnet, dass** die Überwachungsschaltung (SS) ein Messeinschaltintervall (MEI) definierter Dauer generiert und zu Beginn und zum Ende dieses Messeinschaltinter-valls (MEI) die Versorgungsspannung (Uᵥ) unter Last (L) erfasst und dass die Überwachungsschaltung (SS) die Differenz zwischen der Versorgungsspannung zu Beginn (U_{VM}) und am Ende (U_{VB}) des Messeinschaltintervalls (MEI) ermittelt und mit einem Referenzwert vergleicht.

7. Steuergerät nach Anspruch 6, **dadurch gekennzeichnet, dass** die Überwachungsschaltung (SS) bei einer Differenz kleiner eines Mindest-referenzwerts eine fehlende Last meldet.

8. Steuergerät nach Anspruch 6 oder 7, **dadurch gekennzeichnet, dass** die Überwachungsschaltung (SS) bei Überschreiten eines Maximalreferenzwertes einen Kurzschluss meldet.

9. Steuergerät nach einem der Ansprüche 6 bis 8, **dadurch gekennzeichnet, dass** die Überwachungsschaltung (SS) ein PWM-unabhängiges Messeinschaltintervall (MEI) generiert.

10. Steuergerät nach einem der Ansprüche 6 bis 9, **dadurch gekennzeichnet, dass** die Überwachungsschaltung (SS) unmittelbar nach dem Messausschaltintervall (MAI) das Messeinschaltintervall (MEI) generiert.

11. Steuergerät nach dem Oberbegriff des Anspruchs 1 oder nach einem der voranstehenden Ansprüche, **dadurch gekennzeichnet, dass** das Steuergerät einen FET-Endstufenschalter zum Schalten eines von einem Spannungsversorgungsanschluss zum Ausgang fließenden Speisestroms für die Last entsprechend den Ein- und Ausschaltintervallen aufweist, dass
eine Einschaltstufe und eine Ausschaltstufe zum Ein- und Ausschalten einer Gate-Spannung des Endstufenschalters vorgesehen sind, welche entsprechend dem Ein- und Ausschaltintervall des PWM-Signals von der Steuerschaltung angesteuert sind,
und dass eine Gate-Spannungsversorgung für die Einschaltstufe zur Erzeugung einer Gate-Versorgungsspannung zum Durchschalten des Endstufenschalters während des Einschaltintervalls vorgesehen ist.

12. Steuergerät nach Anspruch 11, **dadurch gekennzeichnet, dass** die Gate-Spannungsversorgung (GSV) eine Ladungspumpenschaltung, umfassend eine zwischen einem Plusanschluss (PLA) und einem Mittelabgriff (MA) in Durchlassrichtung liegende Diode (D2) und einen zwischen dem Mittelabgriff (MA) und einem Minusanschluss (MIA) liegenden Kondensator (C1), aufweist, dass der Mittelabgriff (MA) mit der Einschaltstufe (ES) verbunden ist und dass ein Potential am Minusanschluss (MIA) der Ladungspumpenschaltung sich entsprechend einem Potential am Ausgang (A) ändert und somit während des Ausschaltintervalls (AIV) ein über die Diode (D2) fließender Strom den Kondensator (C1) auflädt und während des gesamten Einschaltintervalls (EIV) die Diode (D2) sperrt und die Kapazität (C1) am Mittelabgriff (MA) eine Gate-Versorgungsspannung (U_{GV}) liefert, welche mindestens einer Spannung am versorgungsseitigen Anschluss (D) des Endstufenschalters (T1) entspricht.

13. Steuergerät nach Anspruch 11 oder 12, **dadurch gekennzeichnet, dass** die Gate-Versorgungsspannung (U_{GV}) dem Gate-Anschluss des Endstufenschalters (T1) ungeregelt zuführbar ist.

14. Steuergerät nach einem der Ansprüche 11 bis 13, **dadurch gekennzeichnet, dass** die Kapazität (C1) in der Ladungspumpenschaltung so dimensioniert ist, dass diese bei für das PWM-Signal vorgesehenem minimalem Ausschaltintervall (AIV) und maximalem Einschaltintervall (EIV) während des gesamten Einschaltintervalls (EIV) eine Gate-Versorgungsspannung (U_{GV}) liefert, welche größer ist als die Spannung am versorgungsseitigen Anschluss (D) des Endstufenschalters (T1).

15. Steuergerät nach einem der Ansprüche 11 bis 14, **dadurch gekennzeichnet, dass** die Leckströme bei der Erzeugung Gate-Spannung (U_{G}) während des gesamten Einschaltintervalls (EIV) die Kapazität (C1) nur so weit entladen, dass deren Spannung am Ende des maximalen Einschaltintervalls (EIV) größer ist als die Spannung am versorgungsseitigen Anschluss (D) des Endstufenschalters (T1).

16. Steuergerät nach einem der Ansprüche 11 bis 15, **dadurch gekennzeichnet, dass** die Kapazität (C1) so dimensioniert ist, dass sie sich während des maximalen Einschaltintervalls (EIV) nicht mehr als zur Hälfte entlädt.

17. Steuergerät nach einem der Ansprüche 11 bis 16, **dadurch gekennzeichnet, dass** das die Gate-Versorgungsspannung (U_{GV}) während des gesamten Einschaltintervalls mindestens 3 Volt über der Spannung am versorgungsseitigen Anschluss (D) des Endstufenschalters (T1) liegt.

18. Steuergerät nach einem der Ansprüche 11 bis 17, **dadurch gekennzeichnet, dass** der Minusanschluss (MIA) der Ladungspumpenschaltung auf einem Potential zwischen dem des ausgangsseitigen Anschlusses (S) des Endstufenschalters (T1) und dem des Ausgangs (A) liegt.

19. Steuergerät nach einem der Ansprüche 11 bis 18, **dadurch gekennzeichnet, dass** der Plusanschluss (PLA) der Ladungspumpenschaltung auf einem Potential liegt, welches mindestens dem am versorgungsseitigen Anschluss (D) des Endstufenschalters (T1) entspricht.

20. Steuergerät nach einem der Ansprüche 11 bis 19, **dadurch gekennzeichnet, dass** der Plusanschluss (PLA) der Ladungspumpenschaltung mit einer Versorgungsleitung (VL) des Steuergeräts verbunden ist.

21. Steuergerät nach Anspruch 10, **dadurch gekennzeichnet, dass** die Versorgungsleitung (VL) auf einer stabilisierten Spannung (U_{VL}) liegt.

22. Steuergerät nach einem der Ansprüche 11 bis 21, **dadurch gekennzeichnet, dass** die an dem Plusanschluss (PLA) der Ladungspumpenschaltung anliegende Spannung (U_{VL}) über einen Kondensator (C2) stabilisiert ist.

23. Steuergerät nach einem der Ansprüche 11 bis 22, **dadurch gekennzeichnet, dass** die Gate-Spannungsversorgung (GSV) ausschließlich Dioden (D1) und Kondensatoren (C1) umfasst.

24. Steuergerät nach einem der Ansprüche 11 bis 23, **dadurch gekennzeichnet, dass** der Einschaltstufe (ES) ein als Tiefpass ausgebildetes Zeitglied (R1, C3) zugeordnet ist.

25. Steuergerät nach Anspruch 24, **dadurch gekennzeichnet, dass** ein Kondensator (C3) des Tiefpasses (R1, C3) zwischen dem Gate-Anschluss (G) und Masse (M) liegt.

26. Steuergerät nach einem der Ansprüche 11 bis 25, **dadurch gekennzeichnet, dass** die Einschaltstufe (ES) einen von der Steuerschaltung (SS) steuerbaren Schalttransistor (ST) aufweist.

27. Steuergerät nach einem der Ansprüche 11 bis 26, **dadurch gekennzeichnet, dass** der Ausschaltstufe (AS) ein als Tiefpass ausgebildetes Zeitglied (R2, C3) zugeordnet ist.

28. Steuergerät nach einem der Ansprüche 11 bis 27, **dadurch gekennzeichnet, dass** die Ausschaltstufe (AS) einen von der Steuerschaltung (SS) geschalteten Schalttransistor (ST) aufweist.

29. Steuergerät nach einem der Ansprüche 11 bis 28, **dadurch gekennzeichnet, dass** eine Zeitkonstante des Tiefpasses für das Einschalten (R1, C3) und/oder das Ausschalten (R2, C3) mindestens einen Faktor fünf größer ist als eine Zeitkonstante einer zur Last (L) parallel geschalteten Freilaufdiode (D1).

## Claims

1. Control device for controlling a load, in particular, a radiator fan motor of a motor vehicle, comprising a control circuit generating in accordance with a set value a pulse width modulation signal having successive switch-on intervals and switch-off intervals, a switch-on stage and a switch-off stage connecting the supply current for the load via a final stage switch in a pulse width modulated manner in accordance with the pulse width modulation signal,
**characterized in that** a measurement tap (MA) connected to a measurement circuit (MS) is provided between the final stage switch (T1) and the load (L), and that a monitoring circuit (SS) generates a measurement switch-off interval (MA) by suppressing at least one pulse width modulation switch-on interval (EIV) and monitors the voltage (U_{A}) at the measurement tap (MA) with the measurement circuit (MS) within the measurement switch-off interval (MA) and compares it to a reference value (U_{GES}).

2. Control device as defined in claim 1, **characterized in that** the measurement circuit (MS) determines the voltage at the measurement tap (MA) at a predetermined monitoring time (tU) within the measurement switch-off interval (MAI).

3. Control device as defined in claim 1 or 2, **characterized in that** the monitoring circuit (SS) checks whether the voltage (U_{A}) at the measurement tap (MA) exceeds a minimum value (U_{GES}).

4. Control device as defined in any one of the preceding claims, **characterized in that** the monitoring circuit (SS) initiates a measurement switch-off interval (MAI) periodically.

5. Control device as defined in the preamble to claim 1 or as defined in any one of the preceding claims, **characterized in that** an additional measurement circuit (MS) is provided for detecting a supply voltage (U_{V}) of the control device.

6. Control device as defined in claim 5, **characterized in that** the monitoring circuit (SS) generates a measurement switch-on interval (MEI) of a defined duration and detects the supply voltage (U_{V}) under load (L) at the beginning and at the end of this measurement switch-on interval (MEI) and that the monitoring circuit (SS) determines the difference between the supply voltage at the beginning (U_{VM}) and at the end (U_{VB}) of the measurement switch-on interval (MEI) and compares this to a reference value.

7. Control device as defined in claim 6, **characterized in that** the monitoring circuit (SS) reports a missing load at a difference smaller than a minimum reference value.

8. Control device as defined in claim 6 or 7, **characterized in that** the monitoring circuit (SS) reports a short circuit when a maximum reference value is exceeded.

9. Control device as defined in any one of claims 6 to 8, **characterized in that** the monitoring circuit (SS) generates a measurement switch-on interval (MEI) independent of pulse width modulation.

10. Control device as defined in any one of claims 6 to 9, **characterized in that** the monitoring circuit (SS) generates the measurement switch-on interval (MEI) immediately following the measurement switch-off interval (MAI).

11. Control device as defined in the preamble to claim 1 or as defined in any one of the preceding claims, **characterized in that** the control device has an FET final stage switch for connecting a supply current for the load in accordance with the switch-on and switch-off intervals, said supply current flowing to the output from a voltage supply connection, that
a switch-on stage and a switch-off stage are provided for the switching on and off of a gate voltage of the final stage switch, said stages being controlled by the control circuit in accordance with the switch-on and switch-off interval of the pulse width modulation signal,
and that a gate voltage supply is provided for the switch-on stage for generating a gate supply voltage for the through connection of the final stage switch during the switch-on interval.

12. Control device as defined in claim 11, **characterized in that** the gate voltage supply (GSV) has a charge pump circuit, comprising a diode (D2) located between a plus connection (PLA) and a centre tap (MA) in forward direction and a capacitor (C1) located between the centre tap (MA) and a minus connection (MIA), that the centre tap (MA) is connected to the switch-on stage (ES) and that a potential at the minus connection (MIA) of the charge pump circuit alters in accordance with a potential at the output (A) and thus during the switch-off interval (AIV) a current flowing via the diode (D2) charges the capacitor (C1) and during the entire switch-on interval (EIV) the diode (D2) is blocked and the capacitor (C1) supplies at the centre tap (MA) a gate supply voltage (U_{GV}) corresponding to at least a voltage at the connection (D) of the final stage switch (T1) on the supply side.

13. Control device as defined in claim 11 or 12, **characterized in that** the gate supply voltage (U_{GV}) is adapted to be supplied to the gate connection of the final stage switch (T1) in an unregulated manner.

14. Control device as defined in any one of claims 11 or 13, **characterized in that** the capacitor (C1) in the charge pump circuit is dimensioned such that with a minimum switch-off interval (AIV) and maximum switch-on interval (EIV) provided for the pulse width modulation signal it supplies a gate supply voltage (U_{GV}) greater than the voltage at the connection (D) of the final stage switch (T1) on the supply side during the entire switch-on interval (EIV).

15. Control device as defined in any one of claims 11 to 14, **characterized in that** the leakage currents during the generation of the gate voltage (U_{G}) discharge the capacitor (C1) during the entire switch-on interval (EIV) only to the extent that its voltage at the end of the maximum switch-on interval (EIV) is greater than the voltage at the connection (D) of the final stage switch (T1) on the supply side.

16. Control device as defined in any one of claims 11 to 15, **characterized in that** the capacitor (C1) is dimensioned such that it is discharged during the maximum switch-on interval (EIV) by no more than half.

17. Control device as defined in any one of claims 11 to 16, **characterized in that** during the entire switch-on interval the gate supply voltage (U_{GV}) is at least 3 volts above the voltage at the connection (D) of the final stage switch (T1) on the supply side.

18. Control device as defined in any one of claims 11 to 17, **characterized in that** the minus connection (MIA) of the charge pump circuit is at a potential between that of the connection (S) of the final stage switch (T1) on the output side and that of the output (A).

19. Control device as defined in any one of claims 11 to 18, **characterized in that** the plus connection (PLA) of the charge pump circuit is at a potential corresponding at least to that at the connection (D) of the final stage switch (T1) on the supply side.

20. Control device as defined in any one of claims 11 to 19, **characterized in that** the plus connection (PLA) of the charge pump circuit is connected to a supply line (VL) of the control device.

21. Control device as defined in claim 10, **characterized in that** the supply line (VL) is at a stabilized voltage (U_{VL}).

22. Control device as defined in any one of claims 11 to 21, **characterized in that** the voltage (U_{VL}) fed to the plus connection (PLA) of the charge pump circuit is stabilized via a capacitor (C2).

23. Control device as defined in any one of claims 11 to 22, **characterized in that** the gate voltage supply (GSV) comprises exclusively diodes (D1) and capacitors (C1).

24. Control device as defined in any one of claims 11 to 23, **characterized in that** a timing circuit (R1, C3) designed as a low pass is associated with the switch-on stage (ES).

25. Control device as defined in claim 24, **characterized in that** a capacitor (C3) of the low pass (R1, C3) is located between the gate connection (G) and ground (M).

26. Control device as defined in any one of claims 11 to 25, **characterized in that** the switch-on stage (ES) has a switching transistor (ST) controllable by the control circuit (SS).

27. Control device as defined in any one of claims 11 to 26, **characterized in that** a timing circuit (R2, C3) designed as a low pass is associated with the switch-off stage (AS).

28. Control device as defined in any one of claims 11 to 27, **characterized in that** the switch-off stage (AS) has a switching transistor (ST) connected by the control circuit (SS).

29. Control device as defined in any one of claims 11 to 28, **characterized in that** a time constant of the low pass for the switching on (R1, C3) and/or the switching off (R2, C3) is greater by at least a factor of five than a time constant of a free-wheeling diode (D1) connected in parallel to the load (L).

## Revendications

1. Appareil de commande destiné à commander une charge, en particulier d'un moteur de ventilation d'un véhicule automobile, 1 comportant un circuit de commande, lequel produit en fonction d'une valeur théorique un signal PMW comprenant des intervalles successifs de mise en et hors circuit, un étage de mise en circuit et un étage de mise hors circuit, desquels commutent selon le signal PMW par l'intermédiaire d'un commutateur d'étage final le courant d'alimentation pour la charge avec une modulation d'impulsions en largeur, **caractérisé en ce qu'**une prise de mesure (MA) est prévue entre le commutateur d'étage final (tri) et la charge (L), laquelle prise est reliée à un circuit de mesure (MS), et **en ce qu'**un circuit de surveillance (SS), en éliminant au moins un intervalle de mise en circuit PWM (EIV), produit un intervalle de mise hors circuit de mesure (MAI) et à l'intérieur de l'intervalle de mise hors circuit de mesure (MAI) avec le circuit de mesure (MS) contrôle la tension (U_{A}) sur la prise de mesure (MA) et la compare à une valeur de référence (U_{GES}).

2. Appareil de commande selon la revendication 1, **caractérisé en ce que** le circuit de mesure (MS) à l'intérieur de l'intervalle de mise hors circuit de mesure (MAI) à un temps de surveillance (tU) défini détermine la tension sur la prise de mesure (MA).

3. Appareil de commande selon la revendication 1 ou 2, **caractérisé en ce que** le circuit de surveillance (SS) contrôle si la tension (U_{A}) sur la prise de mesure (MA) dépasse une valeur minimale (U_{GES}).

4. Appareil de commande selon l'une quelconque des revendications précédents, **caractérisé en ce que** le circuit de surveillance (SS) initie périodiquement un intervalle de mise hors circuit de mesure (MAI).

5. Appareil de commande selon le préambule de la revendication 1 ou selon l'une quelconque des revendications précédentes, **caractérisé en ce qu'**un autre circuit de mesure (MS) est prévu, lequel, détecte une tension d'alimentation (UV) de l'appareil de commande.

6. Appareil de commande selon la revendication 5, **caractérisé en ce que** le circuit de surveillance (SS) génère un intervalle de mise en circuit de mesure (MEI) d'une durée définie et au début et à la fin de cet intervalle de mise en circuit de mesure (MEI) détecte la tension d'alimentation (Uᵥ) en charge (L) et **en ce que** le circuit de surveillance (SS) détermine la différence entre la tension d'alimentation au début (U_{VM}) et à la fin (U_{VA}) de l'intervalle de mise en circuit de mesure (MEI) et la compare à une valeur de référence.

7. Appareil de commande selon la revendication 6, **caractérisé en ce que** le circuit de surveillance (SS), lorsqu'une différence est inférieure à une valeur de référence minimale, signale une charge défaillante.

8. Appareil de commande selon la revendication 6 ou 7, **caractérisé en ce que** le circuit de surveillance (SS), lorsqu'une valeur de référence maximale est dépassée, signale un court-circuit.

9. Appareil de commande selon l'une quelconque des revendications 6 à 8, **caractérisé en ce que** le circuit de surveillance (SS) génère un intervalle de mise en circuit de mesure (MEI) indépendant du PMW.

10. Appareil de commande selon l'une quelconque des revendications 6 à 9, **caractérisé en ce que** le circuit de surveillance (SS) génère directement après l'intervalle de mise hors circuit de mesure (MAI) l'intervalle de mise en circuit de mesure (MEI).

11. Appareil de commande selon le préambule de la revendication 1 ou selon l'une quelconque des revendications précédentes, **caractérisé en ce que** l'appareil de commande comprend un commuta teur d'étage final FET destiné à commuter un courant d'alimentation circulant d'un raccord d'alimentation en tension à la sortie pour la charge en fonction des intervalles de mise en et hors circuit,
• **en ce qu'**un étage de mise en circuit et un étage de mise hors circuit destinés à mettre en et hors circuit une tension de grille du commutateur d'étage final sont prévus, lesquels sont commandés par le circuit de commande en fonction de l'intervalle de mise en et hors circuit du signal PMW,
• et **en ce qu'**une alimentation en tension de grille pour l'étage de mise en circuit destinée à produire une alimentation en tension de grille est prévue pour commuter en transit le commutateur d'étage final pendant l'intervalle de mise en circuit.

12. Appareil de commande selon la revendication 11, **caractérisé en ce que** l'alimentation en ten sion de grille (GSV) comprend un circuit à pompe de charge, comportant une diode (D2) située entre un raccord positif (PLA) et une prise centrale (MA) dans la direction de passage et un condensateur (C1) situé entre la prise centrale (MA) et un raccord négatif (MIA), **en ce que** la prise centrale (MA) est reliée à l'étage de mise en circuit (ES) et **en ce qu'**un potentiel sur le raccord négatif (MIA) du circuit à pompe de charge varie en fonction d'un potentiel sur la sortie (A) et ainsi pendant l'intervalle de mise hors circuit (AIV) un courant circulant par la diode (D2) recharge le condensateur (C1) et pendant tout l'intervalle de mise en circuit (EIV) la diode est bloquante et la capacité (C1) sur la prise centrale (MA) fournit une tension d'alimentation de grille (U_{GV}), laquelle correspond au moins à une tension sur le raccord côté alimentation (D) du commutateur d'étage finals (T1).

13. Appareil de commande selon la revendication 11 ou 12, **caractérisé en ce que** la tension d'alimentation de grille (U_{GV}) peut être amenée de façon non réglée au raccord de grille du commutateur d'étage final (T1).

14. Appareil de commande selon l'une quelconque des revendications 11 à 13, **caractérisé en ce que** la capacité (C1) dans le circuit à pompe de charge est dimensionnée de sorte que celui-ci., dans le cas de l'intervalle minimal de mise hors circuit (AIV) prévu pour le signal PMW et de l'intervalle maximal de mise en circuit (EIV) pendant tout l'intervalle de mise en circuit. (EIV), fournit une tension d'alimentation de grille (U_{GV}), laquelle est supérieure à la tension sur le raccord côté alimentation (D) du commutateur d'étage final (T1).

15. Appareil de commande selon l'une quelconque des revendications 11 à 14, **caractérisé en ce que** les courants de fuite lors de à production d'une tension de grille (U_{G}) pendant tout l'intervalle de mise en circuit (EIV) ne déchargent la capacité (C1) que dans la mesure où la tension de celle-ci à la fin de l'intervalle maximale de mise en circuit (EIV) est supérieure à la tension sur le raccord côté alimentation (D) du commutateur d'étage final (T1).

16. Appareil de commande selon l'une quelconque des revendications 11 à 15, **caractérisé en ce que** la capacité (C1) est dimensionnée de sorte qu'elle ne se décharge pas plus qu'à moitié pendant l'intervalle maximal de mise en circuit (EIV).

17. Appareil de commande selon l'une quelconque des revendications 11 à 16, **caractérisé en ce que** la tension d'alimentation de grille (U_{GV}) pendant tout l'intervalle de mise en circuit se situe au moins à 3 Volt au-dessus de la tension sur le raccord côté alimentation (D) du commutateur d'étage final (T1).

18. Appareil de commande selon l'une quelconque des revendications 11 à 17, **caractérisé en ce que** le raccord négatif (MIA) du circuit à pompe de charge se situe à un potentiel compris entre celui du raccord côté sortie (S) du commutateur d'étage final (T1) et celui de la sortie (A).

19. Appareil de commande selon l'une quelconque des revendications 11 à 18, **caractérisé en ce que** le raccord positif (PLA) du circuit à pompe de charge se situe à un potentiel, lequel correspond au moins à celui sur le raccord côté alimentation (D) du commutateur d'étage final (T1).

20. Appareil de commande selon l'une quelconque des revendications 11 à 19, **caractérisé en ce que** le raccord positif (PLA) du circuit à pompe de charge est relié à une conduite d'alimentation (VL) de l'appareil de commande.

21. Appareil de commande selon la revendication 10, **caractérisé en ce que** la conduite d'alimentation (VL) se situe à une tension stabilisée (U_{VL}).

22. Appareil de commande selon l'une quelconque des revendications 11 à 21, **caractérisé en ce que** la tension (U_{VL}) appliquée sur le raccord positif (PLA) du circuit à pompe de charge est stabilisée par un condensateur (C2).

23. Appareil de commande selon l'une quelconque des revendications 11 à 22, **caractérisé en ce que** l'alimentation en tension de grille (GSV) comporte exclusivement des diodes (D1) et des condensateurs (C1).

24. Appareil de commande selon l'une quelconque des revendications 11 à 23, **caractérisé en ce qu'**un élément de temporisation (R1, C3) réalisé comme un filtre passe-bas est associé à l'étage de mise en circuit (ES).

25. Appareil de commande selon la revendication 24, **caractérisé en ce qu'**un condensateur (C3) du filtre passe-bas (R1, C3) se situe entre le raccord de grille (G) et la masse (M).

26. Appareil de commande selon l'une quelconque des revendications 11 à 25, **caractérisé en ce que** l'étage de mise en circuit (ES) comprend un transistor de commutation (ST) pouvant être commandé par le circuit de commande (SS) .

27. Appareil de commande selon l'une quelconque des revendications 11 à 26, **caractérisé en ce qu'**un élément de temporisation (R2, C3) réalisé comme un filtre passe-bas est associé à l'étage de mise hors circuit (AS).

28. Appareil de commande selon l'une quelconque des revendications 11 à 27, **caractérisé en ce que** l'étage de mise hors circuit (AS) comprend un transistor de commutation (ST) commuté par le circuit de commande (SS).

29. Appareil de commande selon l'une quelconque des revendications 11 à 28, **caractérisé en ce qu'**une constante de temps du filtre passe-bas pour la mise en circuit (R1, C3) et/ou la mise hors circuit (R2, C3) est supérieure d'au moins un facteur cinq à une constante de temps d'une diode de roue libre (D1) commutée parallèlement à la charge (L).
